(19) Europäisches Patentamt / European Patent Office / Office européen des brevets

(11) **EP 3 015 976 A1**

(12) **DEMANDE DE BREVET EUROPEEN**

(43) Date de publication:
**04.05.2016 Bulletin 2016/18**

(21) Numéro de dépôt: **15189478.9**

(22) Date de dépôt: **13.10.2015**

(51) Int Cl.:
*G06F 3/16* (2006.01)    *G06F 3/0484* (2013.01)
*G06F 3/0488* (2013.01)    *H03G 5/00* (2006.01)
*H03G 5/16* (2006.01)

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA**

(30) Priorité: **28.10.2014 FR 1460350**

(71) Demandeur: **Parrot**
**75010 Paris (FR)**

(72) Inventeurs:
• LHUILLERY, Frédéric
**75010 Paris (FR)**
• BEURTON, Pierre
**75010 Paris (FR)**

(74) Mandataire: **Dupuis-Latour, Dominique et al**
**Bardehle Pagenberg**
**10, boulevard Haussmann**
**75009 Paris (FR)**

(54) **SYSTÈME DE RESTITUTION SONORE AVEC UNE INTERFACE TACTILE DE SÉLECTION ET DE RÉGLAGE DES ÉGALISATIONS**

(57) Ce système comprend un processeur de signal numérique capable d'appliquer des traitements sur un signal audio à restituer, une interface tactile (130) affichant des indications correspondant à une pluralité de préréglages de traitement ayant des paramètres de traitement prédéterminés, et pouvant recevoir des commandes tactiles pour le déplacement continu d'un curseur d'ajustement du traitement. Les paramètres à appliquer au processeur de signal numérique sont calculés en fonction des paramètres prédéterminés desdits préréglages et de la position du curseur d'ajustement par rapport auxdites différentes positions d'indication de préréglages, pour permettre ainsi d'appliquer un traitement résultant d'une combinaison des préréglages en question. Application notamment à la réalisation de réglages d'égalisation multiples, de façon intuitive, pour un casque d'écoute.

Fig. 2

**EP 3 015 976 A1**

**Description**

La présente invention concerne d'une façon générale les systèmes audio, et plus particulièrement les moyens de réglage de restitution sonore de tels systèmes, notamment les systèmes avec une restitution par casque audio.

Certains casques audio embarquent une batterie rechargeable et un circuit de réception sans fil, par exemple radio (typiquement selon les spécifications *Bluetooth* (marque déposée) ou infrarouge), apte à recevoir les signaux audio véhiculés par un tel canal pour les décoder et les transformer en signaux sonores analogiques appliqués aux transducteurs.

Les casques audio les plus récents abritent également des circuits électroniques de traitement audio destinés à réaliser une égalisation, à appliquer des effets sonores, à contrôler dynamiquement le volume de restitution, à neutraliser les bruits ambiants, etc.

Dans certains cas, les réglages d'égalisation et d'effets sonores sont sélectionnés dans une liste de préréglages ou *presets* au choix de l'utilisateur, par commande à l'aide d'une interface située sur un dispositif distant tel qu'un terminal intelligent ou *smartphone* communiquant avec le casque audio, typiquement par une liaison sans fil selon le protocole de communication *Bluetooth.* Le casque commercialisé par la société déposante sous la dénomination commerciale *Zik* (marque déposée) possède de telles fonctionnalités.

Les US 2012/0063614 A1 et US 2014/0173519 A1 décrivent de telles interfaces de sélection et de contrôle de différents préréglages de restitution sonore par des commandes appropriées mises à la disposition de l'utilisateur.

La présente invention vise à enrichir les possibilités de réglages, notamment de réglages d'égalisation sonore, tout autorisant l'utilisateur à effectuer ces réglages d'une manière particulièrement simple et intuitive. L'invention propose ainsi un système de restitution sonore comprenant, comme divulgué par le US 2012/0063614 A1 précité :

- un processeur de signal numérique capable d'appliquer des traitements sur un signal audio à restituer en fonction de paramètres ;
- une interface utilisateur à écran tactile apte à afficher dans des positions prédéterminées des indications correspondant à une pluralité de préréglages de traitement ayant des paramètres de traitement prédéterminés, et à recevoir des commandes tactiles pour le déplacement continu d'un curseur d'ajustement du traitement ; et
- des moyens pour calculer des paramètres à appliquer au processeur de signal numérique en fonction des paramètres prédéterminés desdits préréglages et de la position du curseur d'ajustement par rapport auxdites différentes positions d'indication de préréglages, pour permettre ainsi d'appliquer un traitement résultant d'une combinaison des préréglages en question.

De façon caractéristique de l'invention, les indications de préréglages de ce système se répartissent en des positions angulairement décalées deux à deux dans une zone ayant une forme de révolution. De plus, le curseur est un curseur unique, tel qu'un déplacement de ce curseur dans une direction radiale par rapport à la forme de révolution permet d'ajuster l'intensité du traitement, tandis qu'un déplacement de ce même curseur dans une direction circonférentielle par rapport à la forme de révolution permet d'ajuster la combinaison entre les préréglages dont les positions d'indication sont les plus proches.

Certaines caractéristiques préférées mais non limitatives de ce système, pouvant être prises en toutes combinaisons jugées par l'homme du métier comme techniquement compatibles, sont les suivantes :

- les préréglages sont des préréglages d'égalisation par bandes de fréquences ;
- les paramètres des préréglages comprennent des paramètres d'un filtrage fréquentiel par bandes ;
- les paramètres à appliquer sont calculés par interpolation en fonction de la distance du curseur par rapport aux deux positions d'indications de préréglages les plus proches du curseur ;
- le système comprend en outre des moyens pour calculer les paramètres à appliquer au processeur de signal numérique en fonction de la position du curseur par rapport à une position de référence correspondant à l'absence de traitement et au moins une position d'indication de préréglage la plus proche, pour ainsi permettre d'ajuster l'intensité du traitement ;
- le système comprend un terminal intelligent comprenant l'interface utilisateur et les moyens de calcul, et un casque d'écoute comprenant le processeur de signal numérique ; et/ou
- le système comprend en outre des moyens de communication sans fil entre le terminal et le casque, aptes à véhiculer le flux audio et les paramètres.

On va maintenant décrire un exemple de mise en oeuvre de l'invention, en référence aux dessins annexés où les mêmes références désignent d'une figure à l'autre des éléments identiques ou fonctionnellement semblables.

La Figure 1 représente schématiquement les différents composants d'un système de restitution sonore pour la mise en oeuvre de la présente invention.

La Figure 2 représente une interface utilisateur préférée pour la mise en oeuvre de l'invention.

La Figure 3 représente des valeurs d'égalisations correspondant à un ensemble de préréglages pouvant être sélectionnés avec l'interface de la Figure 2.

La Figure 4 illustre les courbes de réponse des filtrages correspondant à ces égalisations.

Les Figures 5a à 5d illustrent un ensemble d'interfaces utilisateur, dont celle de la Figure 2, pouvant être utilisées pour la mise en oeuvre d'un ensemble de fonctionnalités liées à la restitution sonore.

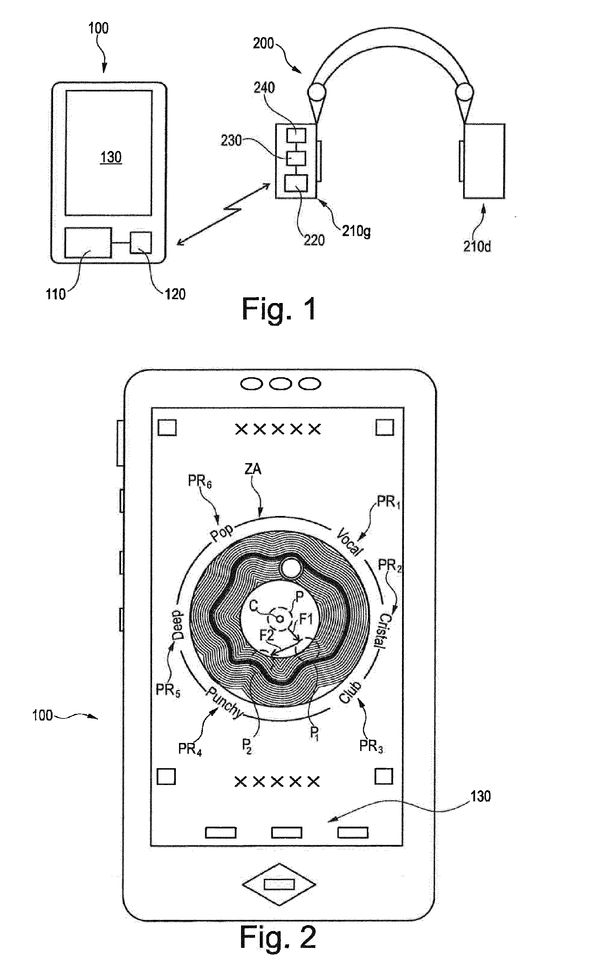

En référence tout d'abord à la Figure 1, on a représenté un système d'écoute audio comprenant un terminal utilisateur 100 et un casque audio 200.

Le terminal 100 est par exemple un téléphone intelligent ou *smartphone* et comporte de façon connue en soi une unité centrale de traitement et ses dispositifs de mémoire et d'entrée/sortie conventionnels, des moyens de communication sans fil par exemple selon les protocoles *WiFi* et *Bluetooth,* et un écran tactile.

On a simplement illustré sur la Figure 1 l'unité centrale de traitement 110, le circuit de communication *Bluetooth* 120 et l'écran tactile 130 du terminal 100, qui sont de types connus en eux-mêmes.

Le casque 200, de type circumaural, comporte de façon classique en soi deux écouteurs gauche et droit 210g et 210d, l'un des écouteurs abritant un circuit de réception *Bluetooth* 220 lui permettant de communiquer avec le terminal 100, un processeur de signal numérique 230 apte à appliquer différents types de traitement (égalisations, réverbération, spatialisation, etc.) au flux sonore reçu par le profil correspondant (typiquement le profil A2DP) du protocole *Bluetooth,* et un amplificateur 240 pour les transducteurs contenus dans les écouteurs gauche et droit.

Un profil adapté du protocole *Bluetooth* permet de transférer au casque 200 à partir du terminal 100 des valeurs de réglages ou paramètres à appliquer sur une entrée de commande du processeur de signal numérique 230 pour modifier les effets appliqués.

L'un des effets pouvant être appliqués par le processeur 230 est un filtrage fréquentiel. Par exemple, le processeur met un oeuvre un filtre à réponse impulsionnelle infinie IIR (*Infinite Impulse Response)* caractérisé par une réponse basée sur les valeurs du signal appliqué en entrée ainsi que sur les valeurs antérieures de la réponse que ce filtre a pu produire. Il peut s'agir notamment d'un filtre IIR d'ordre 2, dit "biquad", dont la fonction de transfert donnant le signal de sortie *y* à l'instant n en fonction du signal d'entrée x aux instants *n, n-1* et *n-2* est donnée par :

$$y(n) = b_0 \cdot x(n) + b_1 \cdot x(n-1) + b_2 \cdot x(n-2) + a_1 \cdot y(n-1) + a_2 \cdot y(n-2)$$

les coefficients $a_1$, $a_2$, $b_0$, $b_1$, $b_2$ de la fonction de transfert étant issus des paramètres $f_0$, $Q$ et $G$ (respectivement fréquence centrale de la bande traitée, largeur de bande ou facteur de qualité, et gain) du filtre.

On va maintenant décrite la façon dont ces coefficients, ou les paramètres eux-mêmes, sont ajustés en réponse à des choix de réglages effectués par l'utilisateur sur le terminal.

En référence à la Figure 2, une interface utilisateur selon un exemple préféré de l'invention comprend, générée sur l'écran tactile 130, une zone de révolution fixe ZA, par exemple circulaire ou annulaire et ici généralement annulaire, sur laquelle on peut déplacer, en réponse à une action de glissement d'un doigt grâce à l'interface d'entrée tactile, un curseur de réglage plus petit, ici une pastille de réglage circulaire P de diamètre sensiblement plus petit que le diamètre extérieur de la zone annulaire ZA. Pour bien marquer la position de la pastille P par rapport à la zone annulaire ZA, la pastille présente une couleur qui tranche nettement par rapport à celle de la zone annulaire. Par exemple, la pastille P présente une couleur vive alors que la zone ZA est représentée en niveaux de gris.

Six positions angulaires sur la zone ZA, mutuellement espacées de 60°, correspondent à six préréglages de filtrage fréquentiel. Ces six positions de préréglages sont désignées par les références $PR_1$ à $PR_6$, et portent chacune, sur un cercle périphérique d'indicateurs CP, des libellés ou indications évoquant les réglages, à savoir *Vocal, Cristal, Club, Punchy, Deep* et *Pop.*

Avantageusement et comme illustré, la zone annulaire ZA présente dans le sens circonférentiel, sur son bord externe et/ou sur son bord interne, des ondulations qui peuvent être représentatives par exemple de certaines caractéristiques de filtrage.

Selon un autre aspect préféré, les bords intérieur et extérieur de la zone annulaire ne sont pas des bords nets, mais des bords flous, avec des niveaux de gris progressivement dégradés vers le blanc en rentrant dans la zone et vers le noir en en sortant.

De façon caractéristique de l'invention, le déplacement de la pastille P de réglage de filtrage fréquentiel permet de faire varier l'égalisation de façon progressive.

Un premier degré de progressivité est réalisé lorsqu'en réponse à l'interface tactile, la pastille P est déplacée du centre géométrique C de la zone annuaire ZA radialement vers l'extérieur.

Lorsque ce déplacement est effectué en direction d'un préréglage donné $PR_n$ (sur la Figure 2, dans le sens de la flèche $F_1$ vers le préréglage $PR_3$ *Club,* position de pastille $P_1$), alors l'unité centrale du terminal 100 calcule, par interpolation entre une intensité d'égalisation nulle (pas d'effet d'égalisation) et une intensité d'égalisation maximale pour ce préréglage $PR_3$, les paramètres d'égalisation à appliquer au processeur de signal numérique.

Cette interpolation est réalisée de préférence en multipliant les paramètres de gain pour chacune des bandes de fréquences (que ce gain soit positif ou négatif), par un coefficient compris entre 0 et 1 et représentatif de la distance radiale entre le centre géométrique C et le centre de la pastille P lorsque la position recherchée de ladite pastille est atteinte (typiquement lorsque l'utilisateur relâche son doigt de l'interface d'entrée tactile après avoir glissé la pastille jusque dans la position souhaitée). Cette distance radiale est déterminée par rapport à une distance radiale maximale, correspondant à l'intensité d'effet maximale, qui de préférence se situe au voisinage du bord externe de la zone annuaire ZA.

Un deuxième degré de progressivité est réalisé lorsqu'en réponse à l'interface tactile, la pastille P est déplacée vers une position située entre deux préréglages $PR_n$ et $PR_{n+1}$.

Lorsqu'un tel déplacement est effectué (sur la Figure 2, dans le sens de la flèche $F_2$ vers la position de pastille $P_2$ située entre les réglages $PR_3$ et $PR_4$ *Club* et *Punchy*), alors l'unité centrale du terminal 100 calcule, par interpolation entre les valeurs d'égalisation du préréglage $PR_3$ et celles du préréglage $PR_4$, les paramètres d'égalisation à appliquer au processeur de signal numérique.

Cette interpolation peut être une interpolation linéaire basée sur la position angulaire de la pastille P par rapport aux positions angulaires, ici espacées mutuellement de 60°, des deux préréglages $PR_3$ et $PR_4$ encadrant la position $P_2$ de la pastille.

On comprend que dans la pratique, le calcul des paramètres à appliquer au processeur de signal numérique tient ainsi compte à la fois de la distance de la pastille P au centre géométrique C et de la position angulaire de ladite pastille dans la zone ZA, le calcul combinant i) une première interpolation entre les paramètres de deux préréglages (sauf lorsque la pastille P se trouve sur un rayon correspondant à un préréglage pur $PR_n$) et ii) une deuxième interpolation entre une égalisation nulle et les paramètres résultant de la première interpolation.

Une fois la pastille amenée à l'aide de l'interface tactile dans la position désirée, et restant immobile dans cette position, les paramètres calculés comme défini ci-dessus sont figés et envoyés au processeur de signal numérique 230 du casque 200. En variante, et de façon préférée, les paramètres sont calculés dynamiquement au cours du déplacement de la pastille P à l'aide de l'interface tactile et envoyés périodiquement vers le processeur 230 pour que l'utilisateur puisse écouter, sur un flux sonore en cours de restitution, l'effet du traitement ainsi ajusté.

De façon préférée, les préréglages sont organisés autour de la zone annuaire ZA de telle façon que deux préréglages angulairement adjacents présentent des paramètres similaires, afin qu'une interpolation entre les valeurs de paramètres de préréglages adjacents ait du sens musicalement.

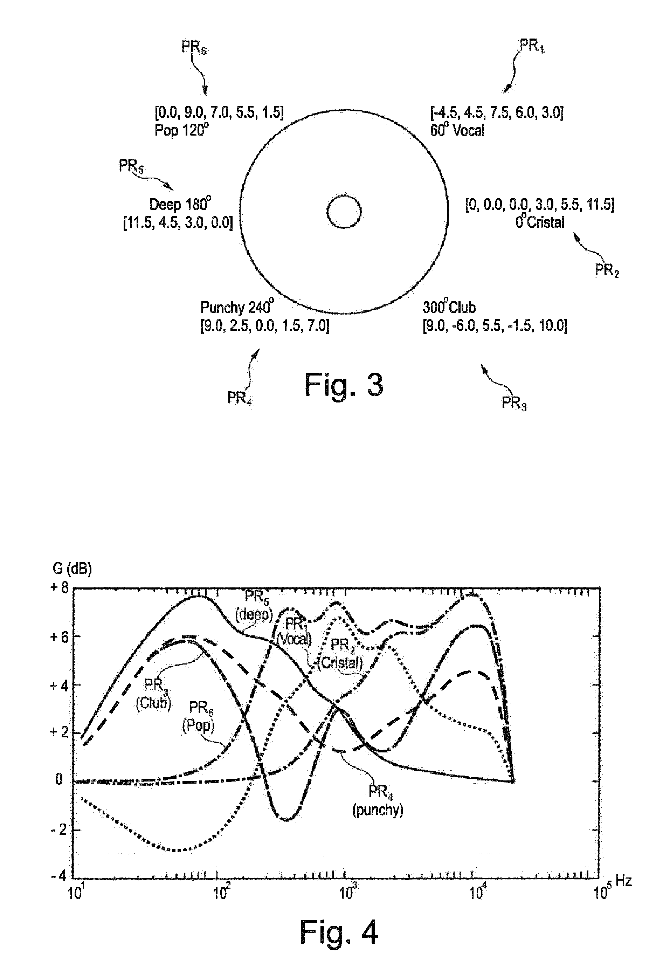

Dans le présent exemple, on prévoit six préréglages dont les valeurs des paramètres sont illustrées sur la Figure 3. Ces paramètres comprennent ici un jeu de cinq valeurs par préréglage, qui correspondent d'une façon générale (sans entrer dans les détails de la mise en oeuvre du filtrage "biquad" à réponse impulsionnelle infinie) à des valeurs de gain dans cinq bandes de fréquences, des graves vers les aigus.

On observe que les préréglage d'égalisation les plus "fins" (riches en aigus et pauvres en graves, tels que les préréglages *Vocal* et *Cristal*), se situent sur la zone annuaire de façon opposée à des préréglages "profonds" ou "épais" tels que *Punchy* et *Deep* qui au contraire sont plutôt riches en graves.

Ceci permet d'éviter notamment qu'une interpolation entre les valeurs de deux préréglages ne risque d'aboutir à une égalisation trop neutre. Au contraire, les réglages musicalement les plus proches (par exemple les paires de réglages *Vocal*/*Cristal Punchy*/*Deep* , etc.) sont adjacents les uns aux autres, de sorte que l'interpolation est susceptible de donner les meilleurs résultats.

La Figure 4 illustre les courbes de réponse en fréquence obtenues avec les différents paramètres illustrés sur la Figure 3. On comprend qu'en interpolant entre eux les paramètres de deux préréglages adjacents (position de la pastille angulairement entre deux préréglages), ainsi qu'en interpolant les paramètres avec ceux d'une correction en fréquence nulle (position de la pastille entre le centre et la zone périphérique externe pour laquelle la correction est maximale), une très large gamme de réglages d'égalisation peut être obtenue, et ce de manière particulièrement simple et intuitive pour l'utilisateur. Notamment, ce dernier n'a pas à connaitre ni à manipuler (comme dans l'art antérieur) des valeurs de fréquence centrale de bande, de facteur de qualité et de gain.

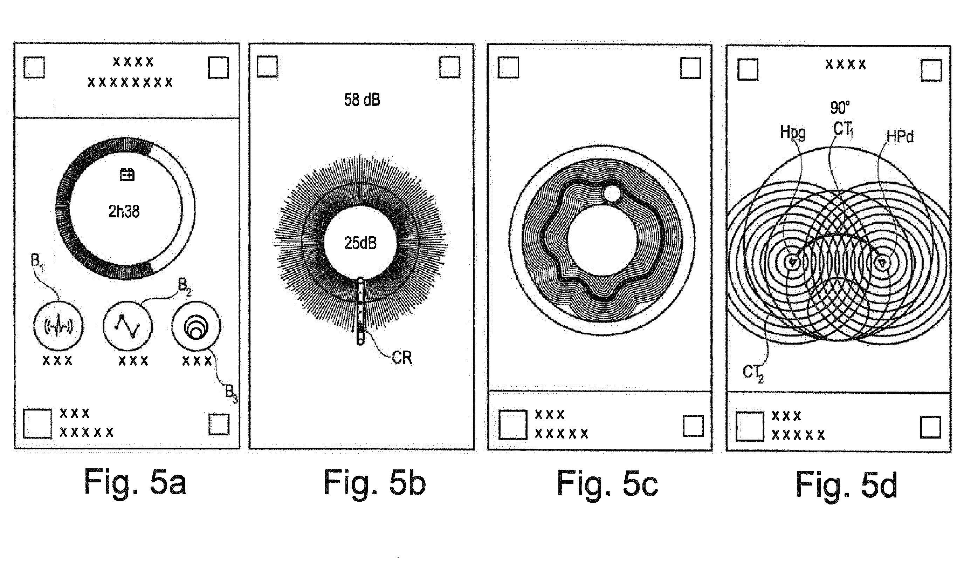

Les Figures 5a à 5d illustrent un ensemble d'interfaces utilisateur pouvant être mises en oeuvre par une application de gestion de diffusion sonore par un casque associé.

La Figure 5a montre l'écran principal, avec au centre une durée restante pour la batterie alimentant le casque, et en bas un ensemble de boutons $B_1$, $B_2$ et $B_3$ permettant d'atteindre les écrans illustrés sur les Figures 5b à 5d. Alternativement, le passage d'un écran à l'autre peut être réalisé par glissement latéral à l'aide du doigt grâce à l'interface tactile.

La figure 5b illustre un écran d'ajustement de la fonction d'annulation de bruit équipant le casque 200.

De façon connue en soi, un circuit d'annulation de bruit d'un casque a pour objectif d'annuler aussi précisément que possible, au niveau de la restitution finale par les transducteurs, le bruit ambiant. Ce circuit fonctionne de façon conventionnelle en captant le bruit ambiant à l'aide d'un microphone intégré au casque, et en superposant au flux sonore à restituer un signal résultant de l'inversion du signal de bruit capté, avec une amplitude correspondant à l'atténuation du bruit par les coussinets du casque. Des traitements plus sophistiqués existent bien entendu, mais l'objectif reste toujours de neutraliser au mieux le bruit ambiant.

Selon cet aspect de l'invention, dont l'homme du métier comprendra qu'il peut être mis en oeuvre de façon entièrement indépendante de la fonction de réglage d'égalisation décrite plus haut, l'utilisateur peut régler le degré d'action du réducteur de bruit de façon progressive entre une action maximale et une désactivation totale, permettant au contraire à l'auditeur de percevoir l'environnement sonore ambiant. Ceci permet d'optimiser le confort d'écoute en fonction de l'usage. Par exemple, lorsque le casque est utilisé comme dispositif mains-libres avec un téléphone mobile (qui en règle générale est le terminal 100 lui-même), ce système peut laisser subsister une certaine proportion du bruit ambiant pour éviter une sensation d'isolement, et également permettre au locuteur de percevoir sa propre voix de façon plus naturelle.

La Figure 5b illustre un curseur de réglage de compensation de bruit CR, qui permet d'ajuster à cet effet de façon continue ou par paliers la compensation du bruit ambiant, entre une valeur de compensation nulle et une valeur de compensation maximale, correspondant à l'annulation. La valeur courante du niveau sonore débruité ("25 dB") est affichée au centre d'un cercle sur un rayon (ici vertical) duquel le curseur CR peut être déplacé avec le doigt de l'utilisateur, le niveau du bruit ambiant réel ("58 dB") étant affiché au-dessus de ce cercle.

La Figure 5c correspond à la Figure 2 décrite plus haut.

Enfin, la Figure 5d est illustre un écran de réglage de simulation de conditions acoustiques d'écoute (en particulier type de réverbération et largeur de l'image stéréophonique en fonction du lieu d'écoute à simuler).

Une série de cercles $CT_1$, $CT_2$ tangents entre eux illustre la taille simulée et/ou le caractère réverbérant ou feutré du lieu d'écoute virtuel, tandis que deux symboles de haut-parleurs $HP_g$, $HP_d$ peuvent être plus ou moins écartés sur le cercle actif à l'aide de l'interface tactile pour sélectivement rétrécir ou élargir l'image stéréophonique.

Bien entendu, la présente invention n'est pas limitée à la forme de réalisation et aux variantes décrites dans ce qui précède, mais l'homme du métier saura y apporter avec ses connaissances générales de nombreuses adaptations. En particulier :

- l'invention s'applique à la restitution sonore par tout type d'équipement, en particulier casque circumaural ou intra-auriculaire, ensemble de haut-parleurs, etc., à liaison filaire ou sans fil ;
- les traitements d'égalisation peuvent être mis en oeuvre par tout type de circuit, numérique ou hybride ;
- dans le cas d'un système à casque d'écoute, les circuits de traitement peuvent être prévus dans le casque comme décrit plus haut mais en variante dans le terminal utilisateur diffusant le flux sonore ;
- le nombre et la disposition des préréglages peuvent largement varier, de même que la représentation graphique des zones dans lesquelles leurs marques sont situées ;
- l'interface utilisateur peut largement varier en fonction du type de dispositif.

**Revendications**

1.  Un système de restitution sonore (100, 200), **caractérisé en ce qu'**il comprend :

    - un processeur de signal numérique (230) capable d'appliquer des traitements sur un signal audio à restituer en fonction de paramètres ;
    - une interface utilisateur à écran tactile (130) apte à afficher dans des positions prédéterminées ($PR_n$) des indications correspondant à une pluralité de préréglages de traitement ayant des paramètres de traitement prédéterminés, et à recevoir des commandes tactiles pour le déplacement continu d'un curseur (P) d'ajustement du traitement ; et
    - des moyens (110) pour calculer des paramètres à appliquer au processeur de signal numérique en fonction des paramètres prédéterminés desdits préréglages et de la position du curseur d'ajustement par rapport auxdites différentes positions d'indication de préréglages, pour permettre ainsi d'appliquer un traitement résultant d'une combinaison des préréglages en question,

    **caractérisé en ce que** :
    - les indications de préréglages ($PR_n$) se répartissent en des positions angulairement décalées deux à deux dans une zone ayant une forme de révolution (ZA) ;
    - le curseur (P) est un curseur unique, tel que :

· un déplacement de ce curseur (P) dans une direction radiale par rapport à la forme de révolution (ZA) permet d'ajuster l'intensité du traitement, tandis que

· un déplacement de ce même curseur (P) dans une direction circonférentielle par rapport à la forme de révolution permet d'ajuster la combinaison entre les préréglages dont les positions d'indication sont les plus proches.

2. Le système de la revendication 1, **caractérisé en ce que** les préréglages sont des préréglages d'égalisation par bandes de fréquences.

3. Le système de la revendication 2, **caractérisé en ce que** les paramètres des préréglages comprennent des paramètres d'un filtrage fréquentiel par bandes.

4. Le système de la revendication 1, **caractérisé en ce que** les paramètres à appliquer sont calculés par interpolation en fonction de la distance du curseur par rapport aux deux positions d'indications de préréglages les plus proches du curseur.

5. Le système de la revendication 1, **caractérisé en ce qu'**il comprend en outre des moyens (110) pour calculer les paramètres à appliquer au processeur de signal numérique (230) en fonction de la position du curseur par rapport à une position de référence (C) correspondant à l'absence de traitement et au moins une position d'indication de préréglage ($PR_n$) la plus proche, pour ainsi permettre d'ajuster l'intensité du traitement.

6. Le système de la revendication 1, **caractérisé en ce qu'**il comprend un terminal intelligent (100) comprenant l'interface utilisateur (130) et les moyens de calcul (110), et un casque d'écoute (200) comprenant le processeur de signal numérique (230).

7. Le système de la revendication 6, **caractérisé en ce qu'**il comprend en outre des moyens de communication sans fil (120, 220) entre le terminal et le casque, aptes à véhiculer le flux audio et lesdits paramètres.

Fig. 1

Fig. 2

PR₆

[0.0, 9.0, 7.0, 5.5, 1.5]
Pop 120°

PR₁

[-4.5, 4.5, 7.5, 6.0, 3.0]
60° Vocal

PR₅

Deep 180°
[11.5, 4.5, 3.0, 0.0]

[0, 0.0, 0.0, 3.0, 5.5, 11.5]
0° Cristal

PR₂

Punchy 240°
[9.0, 2.5, 0.0, 1.5, 7.0]

300° Club
[9.0, -6.0, 5.5, -1.5, 10.0]

PR₄

PR₃

Fig. 3

Fig. 4

Fig. 5a

Fig. 5b

Fig. 5c

Fig. 5d

EP 3 015 976 A1

Europäisches
Patentamt

European
Patent Office

Office européen
des brevets

# RAPPORT DE RECHERCHE EUROPEENNE

Numéro de la demande

EP 15 18 9478

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | US 2014/173519 A1 (SASSI ANTTI HEIKKI TAPIO [FI]) 19 juin 2014 (2014-06-19) * alinéas [0008] - [0039], [0078] - [0105]; figures 2, 5 * | 1-7 | INV. G06F3/16 G06F3/0484 |
| Y | ----- US 2012/063614 A1 (CROCKETT BRETT G [US] ET AL) 15 mars 2012 (2012-03-15) * alinéas [0006], [0025] - [0030], [0108] - [0137]; figures 2, 7-9 * | 1-7 | ADD. G06F3/0488 H03G5/00 H03G5/16 |
| Y | ----- Daniel Pascoal: "Parrot Zik : le test", CNET France, 24 juillet 2012 (2012-07-24), XP055197216, Extrait de l'Internet: URL:http://www.cnetfrance.fr/produits/parrot-zik-39774039.htm [extrait le 2015-06-22] * page 3, ligne 6 - page 4, ligne 9 * ----- | 6,7 | |

DOMAINES TECHNIQUES RECHERCHES (IPC)

G06F
G10H
H03G
H04R

Le présent rapport a été établi pour toutes les revendications

| Lieu de la recherche | Date d'achèvement de la recherche | Examinateur |
|---|---|---|
| Munich | 11 février 2016 | Joder, Cyril |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................................
& : membre de la même famille, document correspondant

EPO FORM 1503 03.82 (P04C02)

## EP 3 015 976 A1

**ANNEXE AU RAPPORT DE RECHERCHE EUROPEENNE
RELATIF A LA DEMANDE DE BREVET EUROPEEN NO.**

EP 15 18 9478

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

11-02-2016

| Document brevet cité au rapport de recherche | Date de publication | Membre(s) de la famille de brevet(s) | | Date de publication |
|---|---|---|---|---|
| US 2014173519 A1 | 19-06-2014 | EP | 2715936 A1 | 09-04-2014 |
| | | US | 2014173519 A1 | 19-06-2014 |
| | | WO | 2012160415 A1 | 29-11-2012 |
| US 2012063614 A1 | 15-03-2012 | TW | 201126516 A | 01-08-2011 |
| | | US | 2012063614 A1 | 15-03-2012 |
| | | WO | 2010138309 A1 | 02-12-2010 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 20120063614 A1

- US 20140173519 A1